# EUROPEAN PATENT APPLICATION

(11) **EP 4 362 089 A1**
(43) Date of publication of application: **01.05.2024**
(21) Application number: 21949679.1
(22) Date of filing: 15.07.2021
(51) Int. Cl.: H01L 23/528, H01L 23/522

(54) **DATA EXCHANGE DEVICE AND METHOD**

(71) Applicant: Huawei Technologies Co., Ltd., Shenzhen, Guangdong 518129 (CN)
(72) Inventor: LIANG, Yu, Shenzhen, Guangdong 518129 (CN); QU, Renjie, Shenzhen, Guangdong 518129 (CN); ZHANG, Ke, Shenzhen, Guangdong 518129 (CN); ZHAO, Yan, Shenzhen, Guangdong 518129 (CN); LAM, Wan, Shenzhen, Guangdong 518129 (CN)
(74) Representative: Grünecker Patent- und Rechtsanwälte PartG mbB
(86) International application number: PCT/CN2021/106580
(87) International publication number: WO 2023/283893

(57) **Abstract**

This application provides a data switching apparatus and a data switching method, and relates to the field of communications technologies, to reduce power consumption and a delay of data switching. The data switching apparatus includes a plurality of dies, and each die includes a divider, a switching unit, a combiner, and four interfaces. An input end of the divider is coupled to a first interface, a first output end of the divider is coupled to a first input end of the switching unit, a second output end of the divider and a second input end of the switching unit are both coupled to a second interface, a first output end of the switching unit is coupled to a first input end of the combiner, a second output end of the switching unit and a second input end of the combiner are both coupled to a third interface, and an output end of the combiner is coupled to a fourth interface. A third interface of each of the plurality of dies is coupled to a third interface of another of the plurality of dies, and a second interface of each of the plurality of dies is coupled to a second interface of still another of the plurality of dies.

## Description

### TECHNICAL FIELD

This application relates to the field of communications technologies, and in particular, to a data switching apparatus and a data switching method.

### BACKGROUND

A switching system is a system for implementing data switching, and needs to meet requirements of non-blocking switching and order preserving. The non-blocking switching means that data paths need to be established between any input port and output port. The order preserving means that when a plurality of data packets of a same data stream from a same input port are output from a same output port, a sequence of output data packets needs to be consistent with that of the input data packets. As hardware for carrying the switching system, a switching chip is usually implemented on a single die (die). However, due to a limitation of a semiconductor manufacturing process, a size of the single die is limited to some extent.

Currently, with continuous increase of network requirements and increase of a switching bandwidth, a scale of the switching system also continuously increases, and it is difficult for a single silicon die to carry the entire switching system. In this case, a plurality of dies may be combined and encapsulated together to form a complete non-blocking switching chip. A current technology provides a switching chip shown in FIG. 1. The switching chip includes 2×2 dies (to be specific, D0, D1, D2, and D3). In each die, die-level input/output (input/output, I/O) interfaces are disposed in two adjacent edge areas, and chip-level I/O interfaces are disposed in the other two adjacent edge areas. The die-level I/O interfaces are used to implement cascading between different dies, and the chip-level I/O interfaces are used as I/O interfaces of the switching chip. When data switching is implemented by using the switching chip, where for example, D0 is a source die, all data received by D0 is written into D0, and then different processing is performed based on different destination dies. Specifically, when the destination die is D1 or D3, D0 sends data to the corresponding die through a die-level I/O interface adjacent to D1 or D3. When the destination die is D2, to implement order preserving, D0 first allocates sequence numbers to a plurality of data packets of a same data stream based on an input sequence, and then forwards the plurality of data packets to D2 separately over two paths: D1 and D3; and D2 writes the received data packets into D2, performs order preserving processing on the data packets on the two paths based on the sequence numbers of the data packets, and then completes a switching process through a corresponding chip-level I/O interface.

In the foregoing technical solution, for data switching between two non-adjacent dies (for example, D0 and D2), switched data needs to be separately written into a source die and a destination die, and the data switching needs to be implemented in two times of switching. Therefore, problems of high power consumption and a long delay exist. In addition, because the switched data is forwarded to the destination die over two paths, delays on the two paths are different. To implement order preserving, the destination die needs to perform order preserving processing only after receiving data packets forwarded over the two paths. Consequently, the delay is further increased.

### SUMMARY

This application provides a data switching apparatus and a data switching method, to reduce power consumption and a delay of data switching in a scenario of cascading between a plurality of dies.

To achieve the foregoing objective, this application uses the following technical solutions.

According to a first aspect, a data switching apparatus is provided, where the data switching apparatus includes a plurality of dies, and each of the plurality of dies includes a divider, a switching unit, a combiner, a first interface, a second interface, a third interface, and a fourth interface; an input end of the divider is coupled to the first interface, a first output end of the divider is coupled to a first input end of the switching unit, a second output end of the divider and a second input end of the switching unit are both coupled to the second interface, a first output end of the switching unit is coupled to a first input end of the combiner, a second output end of the switching unit and a second input end of the combiner are both coupled to the third interface, and an output end of the combiner is coupled to the fourth interface; and a third interface of each of the plurality of dies is coupled to a third interface of another of the plurality of dies, and a second interface of each of the plurality of dies is coupled to a second interface of still another of the plurality of dies (where alternatively, the foregoing descriptions may be understood as that, the plurality of dies include a plurality of die sets, third interfaces of dies that belong to a same die set are coupled, and second interfaces of dies that belong to different die sets are coupled).

In the foregoing technical solution, the plurality of dies may include the plurality of die sets. Each die in the plurality of die sets is coupled to a die in a same die set and a die in a different die set through corresponding interfaces, so that data switching can be implemented in a same die set and between different die sets, and a path is unique when data is transmitted between the different die sets. Therefore, order preserving processing does not need to be performed on the source die and the destination die, so that power consumption and a delay of data switching are reduced.

In a possible implementation of the first aspect, the plurality of dies are interconnected to form a switch fabric, and the first interface and the fourth interface of each of the plurality of dies are respectively configured to serve as an input interface and an output interface of the switch fabric. In the foregoing possible implementation, the plurality of dies are interconnected to form the switch fabric, so that I/O interfaces of the apparatus can be increased, and switching performance of the apparatus is further improved.

In a possible implementation of the first aspect, the plurality of dies include a first die, a second die, a third die, and a fourth die, a third interface of the first die is coupled to a third interface of the second die, a third interface of the third die is coupled to a third interface of the fourth die, a second interface of the first die is coupled to a second interface of the third die, and a second interface of the second die is coupled to a second interface of the fourth die. In the foregoing possible implementation, the first die, the second die, the third die, and the fourth die may be directly interconnected, so that loads of the dies can be further reduced, and an area of the apparatus can be reduced.

In a possible implementation of the first aspect, the plurality of dies include a plurality of rows and a plurality of columns, and dies in a same row are one die set, or dies in a same column are one die set. In the foregoing possible implementation, a simple and flexible die set division manner is provided. Die sets obtained through division in this manner can reduce a delay of data transmission between different dies in a same die set and between dies in different die sets.

In a possible implementation of the first aspect, for the first die, the divider is configured to: receive first data through an input end of the divider, and output the first data through a first output end of the divider when a destination die of the first data and the first die belong to a same die set, or output the first data through a second output end of the divider when a destination die of the first data and the first die belong to different die sets; the switching unit is configured to: receive second data through a first input end and a second input end of the switching unit, and output the second data through a first output end of the switching unit when a destination die of the second data is the first die, or output the second data through a second output end of the switching unit when a destination die of the second data is not the first die; and the combiner is configured to: receive third data through a first input end and a second input end of the combiner, and output the third data through an output end of the combiner. In the foregoing possible implementation, different dies in a same die set and dies in different die sets can be coupled through corresponding interfaces, so that data switching can be implemented in a same die set and between different die sets, and a path is unique when data is transmitted between dies. Therefore, the power consumption and the delay are reduced.

In a possible implementation of the first aspect, each die includes M×N switching slices, each of the M×N switching slices includes a splitter, a switching unit, a combiner, a first interface, a second interface, a third interface, and a fourth interface, and M and N are positive integers; and second interfaces of switching slices that belong to a same row in the M×N switching slices are coupled through a first bus, and third interfaces of switching slices that belong to a same column are coupled through a second bus. In the foregoing possible implementation, when each die includes a plurality of switching slices, an I/O interface of a single die may be added. Therefore, when a plurality of dies form a complete apparatus, I/O interfaces of the apparatus can be increased, so that the switching performance of the apparatus is further improved.

In a possible implementation of the first aspect, the plurality of die sets include a first die set, the first die set includes a first die and a second die, M×N switching slices included in the first die are in a one-to-one correspondence with M×N switching slices included in the second die, and third interfaces of two corresponding switching slices are coupled. In the foregoing possible implementation, uniqueness of a path for data transmission between different dies in a same die set can be ensured, so that the power consumption and the delay of data switching are reduced.

In a possible implementation of the first aspect, the plurality of die sets include a first die set and a second die set, the first die set includes a first die, the second die set includes a third die, M×N switching slices included in the first die are in a one-to-one correspondence with M×N switching slices included in the third die, and second interfaces of two corresponding switching slices are coupled. In the foregoing possible implementation, uniqueness of a path for data transmission between two dies in different die sets can be ensured, so that the power consumption and the delay of data switching are reduced.

In a possible implementation of the first aspect, the third interface of each die in a same die set corresponds to at least one virtual output interface, and at least one virtual output port of one die in the same die set is in a one-to-one correspondence with a fourth interface of another die than the die in the die set. Optionally, in an example in which the plurality of dies includes four dies, there is one virtual output interface corresponding to a third interface of either of two dies that are in the plurality of dies and whose third interfaces are coupled, and the virtual output port of either of the two dies is corresponding to a fourth interface of the other die. In the foregoing possible implementation, when data is switched between two dies that belong to different rows or columns and that are in different die sets, data switching is performed only once, so that the power consumption and the delay of data switching are reduced.

In a possible implementation of the first aspect, data switched between two dies that belong to different die sets is written into a die in a die set in which a destination die is located. In the foregoing possible implementation, when data is switched between two dies that belong to different die sets, the data only needs to be written into one die, so that the power consumption and the delay of data switching are reduced.

In a possible implementation of the first aspect, when a source die and the destination die in the two dies belong to a same row or column, the data is written into the destination die; or when a source die and the destination die in the two dies belong to different rows or columns, the data is written into a die that is in the die set in which the destination die is located and that is in a same row or column as the source die. In the foregoing possible implementation, when data is switched between two dies that belong to different die sets, the data only needs to be written into one die, so that the power consumption and the delay of data switching are reduced.

In a possible implementation of the first aspect, data switched between two dies that belong to a same die set is written into a source die. In the foregoing possible implementation, when data is switched between two dies that belong to a same die set, the data only needs to be written into one die, so that the power consumption and the delay of data switching are reduced.

According to a second aspect, a chip is provided. The chip includes the data switching apparatus provided in any one of the first aspect or the possible implementations of the first aspect.

According to a third aspect, a data switching device is provided. The data switching device includes the data switching apparatus provided in any one of the first aspect or the possible implementations of the first aspect.

According to a fourth aspect, a data switching method is provided, applied to a data switching apparatus including a plurality of dies, where the plurality of dies include a first die, and the method includes: The first die receives data from the outside; if a destination die of the data is the first die, the first die outputs the data; or if the destination die of the data is a proxy die, the first die sends the data to the proxy die, and the proxy die outputs the data to the outside, where the proxy die and the first die belong to a same die set; and if the destination die of the data is a shadow die, the first die sends the data to the shadow die, and the shadow die outputs the data, where the shadow die and the first die belong to different die sets, but belong to a same row or a same column; or if the destination die of the data is another die in a die set in which the shadow die is located, the first die sends the data to the shadow die, and the shadow die forwards the data to the destination die, so that the destination die outputs the data.

In a possible implementation of the fourth aspect, each of the plurality of dies includes a divider, a switching unit, a combiner, a first interface, a second interface, a third interface, and a fourth interface. An input end of the divider is coupled to the first interface, a first output end of the divider is coupled to a first input end of the switching unit, a second output end of the divider and a second input end of the switching unit are both coupled to the second interface, a first output end of the switching unit is coupled to a first input end of the combiner, a second output end of the switching unit and a second input end of the combiner are both coupled to the third interface, and an output end of the combiner is coupled to the fourth interface. The plurality of dies include a plurality of die sets, third interfaces of dies that belong to a same die set are coupled, and second interfaces of dies that belong to different die sets are coupled. For each of the plurality of dies, the method includes: The divider receives first data through the input end of the divider, and outputs the first data through the first output end of the divider when a destination die of the first data and the first die belong to a same die set, or outputs the first data through the second output end of the divider when a destination die of the first data and the first die belong to different die sets; the switching unit receives second data through the first input end and the second input end of the switching unit, and outputs the second data through the first output end of the switching unit when a destination die of the second data is the first die, or outputs the second data through the second output end of the switching unit when a destination die of the second data is not the first die; and the combiner receives third data through the first input end and the second input end of the combiner, and outputs the third data through the output end of the combiner.

In a possible implementation of the fourth aspect, the third interface of each die in a same die set corresponds to at least one virtual output interface, and at least one virtual output port of one die in the same die set is in a one-to-one correspondence with a fourth interface of another die than the die in the die set.

In a possible implementation of the fourth aspect, data switched between two dies that belong to different die sets is written into a die in a die set in which a destination die is located.

In a possible implementation of the fourth aspect, when a source die and the destination die in the two dies belong to a same row or column, the data is written into the destination die; or when a source die and the destination die in the two dies belong to different rows or columns, the data is written into a die that is in the die set in which the destination die is located and that is in a same row or column as the source die.

In a possible implementation of the fourth aspect, data switched between two dies that belong to a same die set is written into a source die.

It should be understood that, for beneficial effects of any chip, data switching device, and data switching method provided above, correspondingly refer to beneficial effects of the data switching apparatus provided above. Details are not described herein again.

### BRIEF DESCRIPTION OF DRAWINGS

FIG. 1 is a schematic diagram of a structure of a switching chip;
FIG. 2 is a schematic diagram of a structure of a switching system according to an embodiment of this application;
FIG. 3 is a schematic diagram of a structure of a data switching apparatus according to an embodiment of this application;
FIG. 4 is a schematic diagram of a structure of another data switching apparatus according to an embodiment of this application;
FIG. 5 is a schematic diagram of a structure of a die according to an embodiment of this application;
FIG. 6 is a schematic diagram of a structure of another die according to an embodiment of this application;
FIG. 7 is a schematic diagram of a structure of still another data switching apparatus according to an embodiment of this application;
FIG. 8 is a schematic diagram of a structure of a switching slice according to an embodiment of this application; and
FIG. 9 is a schematic flowchart of a data switching method according to an embodiment of this application.

### DESCRIPTION OF EMBODIMENTS

The following describes technical solutions in embodiments of this application with reference to the accompanying drawings in embodiments of this application. In this application, "at least one" means one or more, and "a plurality of" means two or more. "And/or" describes an association relationship between associated objects, and indicates that three relationships may exist. For example, A and/or B may indicate the following three cases: A exists alone, both A and B exist, and B exists alone, where A and B may be singular or plural. The character "/" usually indicates an "or" relationship between the associated objects. "At least one of the following items (pieces)" or a similar expression thereof means any combination of these items, including any combination of singular items (pieces) or plural items (pieces). For example, at least one of a, b, or c may represent: a, b, c, a and b, a and c, b and c, or a, b, and c, where a, b, and c may be singular or plural. In addition, in embodiments of this application, terms such as "first" and "second" are not intended to limit a quantity or an execution sequence.

It should be noted that, in this application, terms such as "example" or "for example" are used to represent an example, an instance, or an illustration. Any embodiment or design scheme described as an "example" or "for example" in this application should not be explained as being more preferred or having more advantages than other embodiments or design schemes. Exactly, use of the words such as "example" or "for example" is intended to present a related concept in a specific manner.

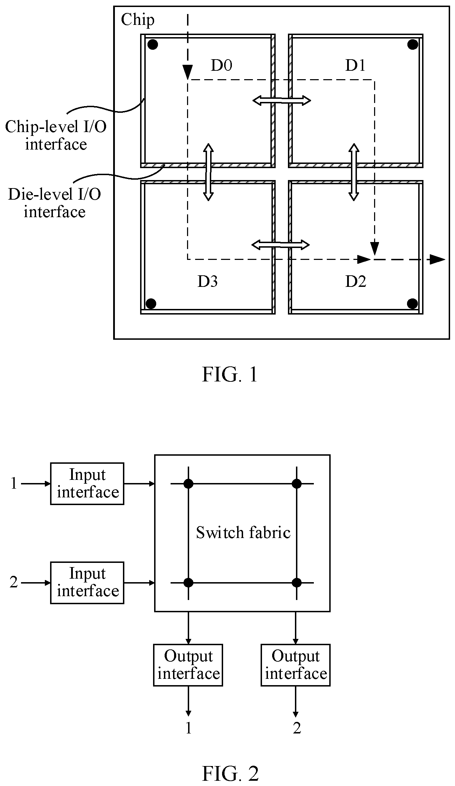

The technical solutions provided in embodiments of this application may be applied to various switching systems for implementing data switching. The switching system may be configured to implement switching of variable-length data packets (packets), or may be configured to implement switching of fixed-length cells (cells). For example, FIG. 2 is a schematic diagram of a structure of an N×N (where N is an integer greater than 1) switching system according to an embodiment of this application. The switching system may include N input interfaces, N output interfaces, and a switch fabric (switch fabric) configured to implement data switching between the N input interfaces and the N output interfaces. The switch fabric may also be referred to as a switching unit.

The N input interfaces may be configured to receive a data packet or a cell from the outside of the switching system. The switch fabric may be configured to: perform classification based on information such as a destination IP address or a destination port of a received data packet or cell, and write the classified data packet or cell into a corresponding queue (queue) for buffering. The switch fabric is further configured to switch the buffered data packet to a corresponding output interface.

It should be noted that, in FIG. 2, an example in which the switching system is a 2×2 switching system is used for description, to be specific, an example in which the switching system includes two input interfaces and two output interfaces is used. In an actual application, the switching system may further include more input interfaces and more output interfaces. FIG. 2 constitutes no limitation on this embodiment of this application.

Further, when the switching system includes more input interfaces and output interfaces, the switching system may be a large-area switching chip (chip) obtained by combining and encapsulating a plurality of dies (dies), where for example, a plurality of dies may be combined and encapsulated by using a chiplet (chiplet) technology to obtain one switching chip. A structure of each die in the plurality of dies may include two input interfaces and two output interfaces as shown in FIG. 2.

When the switching system is obtained by combining and encapsulating a plurality of dies, the plurality of dies may be a plurality of identical dies obtained in one tapeout process or same tapeout processes, and dies at different positions in the switching system may be obtained by configuring and rotating the plurality of dies. This can greatly reduce development costs of the dies.

In addition, each die may switch data by using an input/output (input/output, I/O) interface. The I/O interface may also be referred to as an I/O port or an I/O port. In an actual application, the I/O interface may be a serial (serdes) interface. When the switching system is obtained by combining and encapsulating a plurality of dies, I/O interfaces of all dies in the plurality of dies may be classified into two types: chip-level I/O interfaces and die-level I/O interfaces. The chip-level I/O interface may be an I/O interface configured to perform data transmission with an external module of the switching chip, and the die-level I/O interface may be an I/O interface configured to perform data transmission between different dies inside the switching chip. The chip-level I/O interface generally has characteristics of high driving capability, large power consumption, and large area. The die-level I/O interface generally has characteristics of low driving capability, small power consumption, small area, and suitable for short-distance transmission.

In a practical application, for chip-level I/O interfaces and die-level I/O interfaces of different dies in a same switching chip, when interconnection between different dies is directly connection through the die-level I/O interfaces, and there is no interval or crossover, in this case, load of the die-level I/O interface is the smallest, the interconnection is the simplest, and engineering implementation costs are the lowest. Therefore, power consumption and an area of the switching chip are greatly advantageous. In addition, if the chip-level I/O interface can be close to an edge of the switching chip, a distance and difficulty of interconnecting the chip-level I/O interface are also reduced, so that the power consumption and the area of the switching chip are reduced.

During die design, as shown in FIG. 1, a chip-level I/O interface is usually disposed in two adjacent edge areas of a die, and a die-level I/O interface is disposed in the other two adjacent edge areas. In addition, considering that a plurality of dies in one switching chip are completely the same, when the plurality of dies are interconnected, different dies may be rotated at different angles. For example, the switching chip shown in FIG. 1 includes 2×2 dies. D1 may be obtained by rotating D0 by 90 degrees clockwise, D2 may be obtained by rotating D0 by 180 degrees clockwise, and D3 may be obtained by rotating D0 by 270 degrees clockwise. Through rotation of different angles, the chip-level I/O interfaces of the plurality of dies may be located outside and the die-level I/O interfaces are located inside, to facilitate direct connection of the die-level I/O interfaces of different dies.

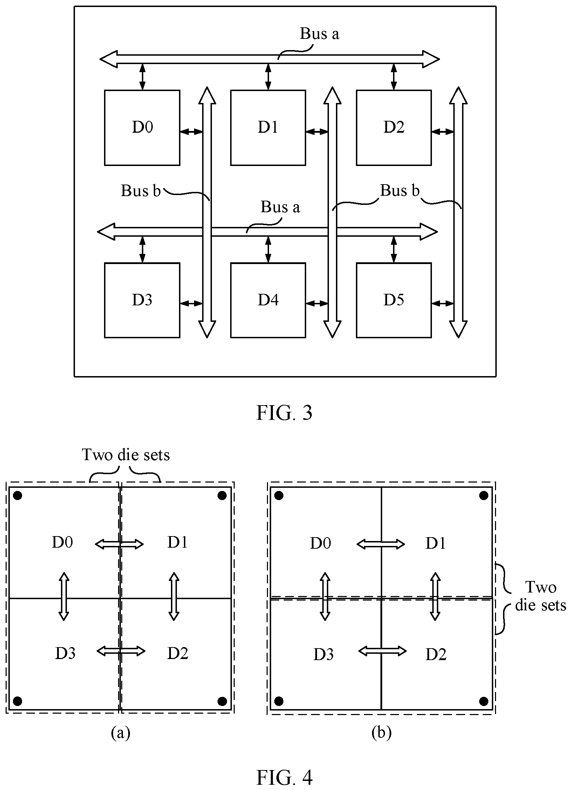

FIG. 3 is a schematic diagram of a structure of a data switching apparatus according to an embodiment of this application. The plurality of dies include X rows and Y columns of dies, and X and Y are integers greater than 1. In FIG. 3, an example in which X=2, Y=3, and the dies of X rows and Y columns are respectively represented as D0 to D5 is used for description.

In four edge areas of each die in the dies of X rows and Y columns, chip-level I/O interfaces are disposed in two adjacent edge areas, and die-level I/O interfaces are disposed in the other two adjacent edge areas. One or more I/O ports may be disposed in each edge area. Chip-level I/O interfaces of the dies of X rows and Y columns are I/O interfaces for data transmission between the apparatus and an external module.

In addition, chip-level I/O interfaces of one edge area of Y dies that belong to a same row in the dies of X rows and Y columns may be connected through a bus a, and chip-level I/O interfaces of one edge area of X dies that belong to a same column may be connected through a bus b.

In addition, a third interface of each of the plurality of dies is coupled to a third interface of one or more dies in the plurality of dies, and a second interface of each of the plurality of dies is coupled to a second interface of one or more dies in the plurality of dies. The foregoing descriptions may alternatively be understood as that, the dies of X rows and Y columns may include a plurality of die sets, and the plurality of die sets may be obtained through division according to rows or columns. In other words, dies in a same row are a die set, or dies in s same column are a die set. The dies in the same row may alternatively be referred to as belonging to a same plane (plane), and the die in a same column may alternatively be referred to as belonging to a same area (area).

Specifically, for any one of the plurality of dies (where for ease of description, the die is referred to as a first die in the following), the first die is configured to: receive data from the outside; if a destination die of the data is the first die, output the data; or if the destination die of the data is a proxy die, send the data to the proxy die, and the proxy die outputs the data to the outside, where the proxy die and the first die belong to a same die set; and if the destination die of the data is a shadow die, send the data to the shadow die, and the shadow die outputs the data, where the shadow die and the first die belong to different die sets, but belong to a same row or a same column; or if the destination die of the data is another die in a die set in which the shadow die is located, sends the data to the shadow die, and the shadow die forwards the data to the destination die, so that the destination die outputs the data.

A die-level I/O interface of each die in a same die set corresponds to at least one virtual output interface. At least one virtual output interface of one die in a same die set is in a one-to-one correspondence with a chip-level I/O interface of another die in the die set than the die. The at least one virtual output interface may be configured to transmit data between two dies that belong to different rows or columns in different die sets. For example, D3 in the plurality of dies is used as an example. If D3, D4, and D5 are a same die set, a die-level I/O interface of D3 may correspond to at least two virtual output interfaces, and the at least two virtual output interfaces may be in a one-to-one correspondence with chip-level I/O interfaces of D4 and D5. If D3 and D0 are a same die set, a die-level I/O interface of D3 may correspond to at least one virtual output interface, and the at least one virtual output interface may be in a one-to-one correspondence with a chip-level I/O interface of D0.

In addition, in a same die set, when data is switched between different chip-level I/O interfaces of a same die or between different dies, the data may be written into a source die. In different die sets, when data is switched between two dies in different die sets, the data may be written into a shadow die of a source die, the shadow die and the source die belong to different die sets, but belong to a same row or column.

For example, the first die is D0. When D0 receives data from the outside, if a destination die of the data is D0, D0 may output the data based on a destination IP address or a destination port of the data. In this case, the data is written into a queue of D0. If the destination die of the data is D1, D0 may send the data to D 1, and D1 outputs the data based on the destination IP address or the destination port of the data. In this case, the data is written into a queue of D1. If the destination die of the data is D3, D0 may send the data to D3, and D3 outputs the data based on the destination IP address or the destination port of the data. In this case, the data is written into a queue of D3. If the destination die of the data is D5, D0 may send the data to D3, and D3 sends the data to D5 based on the destination IP address or the destination port of the data, so that D5 directly outputs the data. In this case, the data is written into a queue of D3.

In the apparatus provided in this embodiment of this application, the plurality of dies may include a plurality of die sets, and each die in the plurality of die sets may be configured to implement data switching in a same die set and between different die sets. In addition, in a data switching process, data needs to be written into only one die, and data switching is performed only once, so that power consumption and a delay of data switching are reduced. In addition, a path for data transmission between different die sets is unique, so that order preserving processing does not need to be performed on a source die and a destination die, and the delay of data switching is further reduced.

In a possible embodiment, as shown in FIG. 4, when the dies of X rows and Y columns are 2×2 dies, the 2×2 dies may be directly interconnected, and the bus a and the bus b do not need to be used for interconnection between dies in different rows or different columns. The 2×2 dies may be respectively represented as D0 to D3. When the 2×2 dies are directly interconnected, in edge areas of each of the 2×2 dies, a die-level I/O interface is disposed in an edge area that has an adjacent die, and a chip-level I/O interface is disposed in an edge area that has no adjacent die. The die-level I/O interface may be directly used to implement data transmission of interconnection between dies, and the chip-level I/O interface may be directly used to implement data transmission between the apparatus and the outside.

A third interface of each of the 2×2 dies is coupled to a third interface of one of the plurality of dies, and a second interface of each of the plurality of dies is coupled to a second interface of another of the plurality of dies. In other words, the 2×2 dies may include two die sets, and either of the two die sets includes two dies in a same row or a same column, (a) in FIG. 4 shows a case in which one die set includes two dies in a same row, and (b) in FIG. 4 shows a case in which one die set includes two dies in a same column. A die-level I/O interface of either of two dies that belong to a same die set in the two die sets corresponds to a virtual output interface. A virtual output interface of one of the two dies corresponds to a chip-level I/O interface of the other die. The virtual output interface is configured to transmit data between two dies that belong to different die sets and are not adjacent to each other.

In the 2×2 dies, data switched between two dies that belong to a same die set is written into a source die. For example, as shown in (a) in FIG. 4, when data is switched between D0 and D3, if D0 is a source die and D3 is a destination die, when D0 receives external data, D0 may write the data into D1 and then send the data to D3, and D3 outputs the data.

In the 2×2 dies, data switched between two adjacent dies that belong to different die sets is written into a destination die. For example, as shown in (a) in FIG. 4, when data is switched between D0 and D1, if D0 is a source die and D1 is a destination die, when D0 receives external data, D0 may direct send the data to D1, and D1 writes the data into D1 and outputs the data.

In the 2×2 dies, data switched between two non-adjacent dies that belong to different die sets is written into another die in a die set in which a destination die is located. For example, as shown in (a) in FIG. 4, when data is switched between D0 and D2, if D0 is a source die and D2 is a destination die, when D0 receives external data, D0 may send the data to D1, and D1 writes the data into D1 and then sends the data to D2, and D2 outputs the data. Optionally, a virtual output interface corresponding to a die-level I/O interface of D1 corresponds to a chip-level I/O interface of D2, so that D1 may write the data through the virtual output interface when writing the data, and D2 may directly output the data when receiving the data.

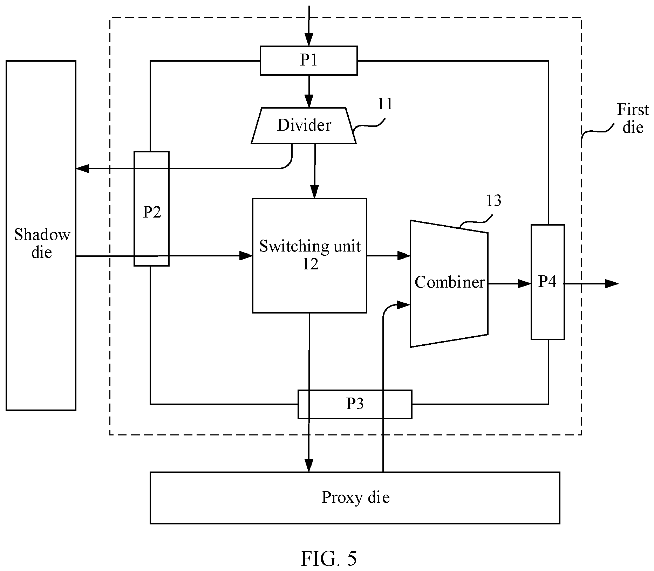

Further, as shown in FIG. 5, each of the plurality of dies may include a divider 11, a switching unit 12, a combiner 13, a first interface P1, a second interface P2, a third interface P3, and a fourth interface P4. An input end of the divider 1 is coupled to the first interface P1, a first output end of the divider 11 is coupled to a first input end of the switching unit 12, a second output end of the divider 11 and a second input end of the switching unit 12 are both coupled to the second interface P2, a first output end of the switching unit 12 is coupled to a first input end of the combiner 13, a second output end of the switching unit 12 and a second input end of the combiner 13 are both coupled to the third interface P3, and an output end of the combiner 13 is coupled to the fourth interface P4. Third interfaces P3 of dies that belong to a same die set in the plurality of dies are coupled, and second interfaces P2 of dies that belong to different die sets are coupled.

Each of the plurality of dies may include at least four interfaces. The at least four interfaces include the first interface P1, the second interface P2, the third interface P3, and the fourth interface P4. The first interface P1 and the fourth interface P4 may be the chip-level I/O interfaces, and the second interface P2 and the third interface P3 may be the die-level I/O interfaces. In an actual application, each die may alternatively include a larger quantity of interfaces. For example, each die may include 8 or 16 interfaces. This is not specifically limited in this embodiment of this application.

Specifically, for any die in the plurality of die chips (where for ease of description, the die is referred to as a first die in the following), when the first die is configured to implement data transmission in a same die set or between different die sets, the divider 11, the switching unit 12, and the combiner 13 in the first die may be configured to perform the following functions.

The divider 11 is configured to: receive first data through an input end of the divider 11, the first data may be data received by the first die through the first interface P1 from the outside; and output the first data through the first output end of the divider 11 when a destination die of the first data and the first die belong to a same die set; or output the first data through the second output end of the divider 11 when a destination die of the first data and the first die belong to different die sets.

The switching unit 12 is configured to: receive second data through the first input end and the second input end of the switching unit 12, where the second data may include data output by the divider 11 through the second output end and data received by the first die through the second interface P2 from a shadow die; and output the second data through the first output end of the switching unit 12 when a destination die of the second data is the first die; or output the second data through the second output end of the switching unit 12 when a destination die of the second data is not the first die.

The combiner 13 is configured to: receive third data through the first input end and the second input end of the combiner 13, where the third data may include data output by the switching unit 2 through the second output end and data received by the first die through the third interface P3 from a proxy die; and output the third data through the output end of the combiner 13, and then the third data may be output through the fourth interface P4 of the first die.

Optionally, each die may further include a unit configured to determine a destination die of data received by the die, and a unit configured to: control the divider 11, the switching unit 12, the combiner 13, and the like. For specific related descriptions of the units with the foregoing functions, refer to descriptions in conventional technologies. This is not described in this embodiment of this application.

When the apparatus provided in this embodiment of this application includes 2×2 dies, the 2×2 dies may be directly interconnected, and the bus a and the bus b do not need to be used for interconnection between dies in different rows or different columns, so that die load can be further reduced while an area of the apparatus is reduced. In addition, for data switching between two non-adjacent dies, data only needs to be written to one die and data switching is performed once in a data switching process, so that power consumption and a delay of data switching are reduced.

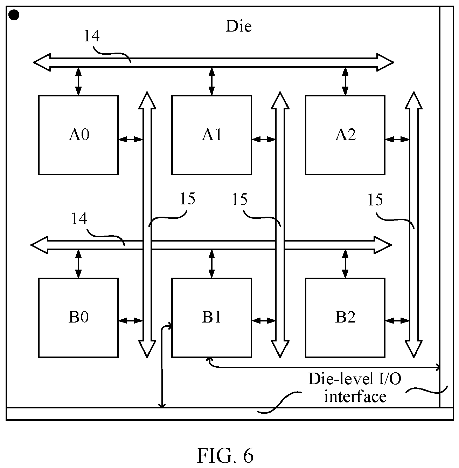

Further, for each die in the plurality of dies, as shown in FIG. 6, each die may include M×N switching slices, and four edge areas of each switching slice may be provided with interfaces. Interfaces that are in a first edge area and that are of switching slices that belong to a same row in the M×N switching slices may be coupled by using a first bus 14, and interfaces that are in a second edge area and that are of switching slices that belongs to a same column may be coupled by using a second bus 15. The first bus 14 and the second bus 15 may be configured to implement data transmission between different switching slices in a same die, and interfaces of a third edge area and a fourth edge area of the M×N switching slices may be die-level I/O interfaces of the die, to implement data transmission between switching slices in different dies. M and N are positive integers. In FIG. 6, an example in which M=2, N=3, and the M×N switching slices are represented as A0 to A2 and B0 to B2 is used for description.

In a possible embodiment, when each of the plurality of dies includes M×N switching slices, M×N switching slices included in any two dies that belong to a same die set are in a one-to-one correspondence. For example, the plurality of die sets include a first die set, the first die set includes a first die and a second die, and M×N switching slices included in the first die are in a one-to-one correspondence with M×N switching slices included in the second die.

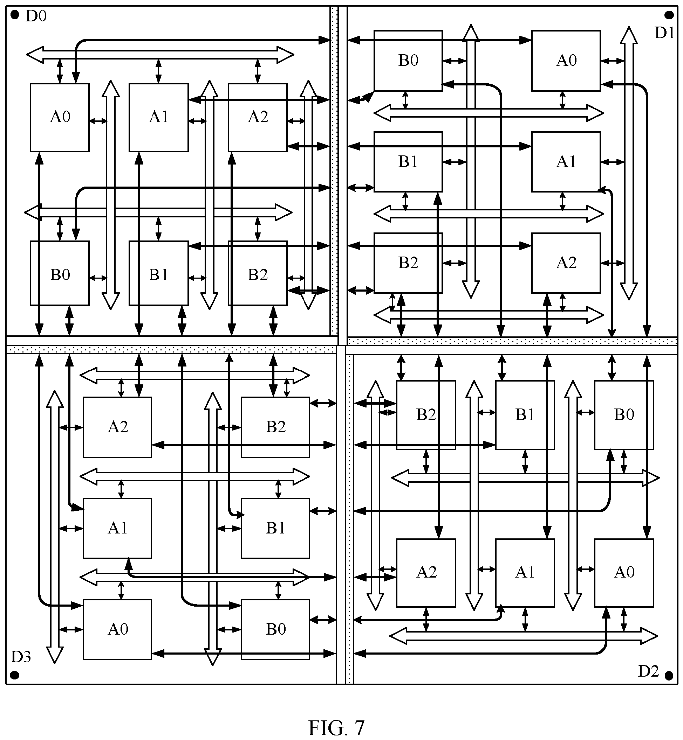

For example, as shown in FIG. 7, an example in which the plurality of die includes 2×2 dies (denoted as D0 to D3 respectively), and each die includes 2×3 switching slices (denoted as A0 to A2 and B0 to B2 respectively) is used. If D0 and D1 belong to the first die set, D0 is the first die, and D1 is the second die, 2×3 switching slices included in D0 and D1 may be in a one-to-one correspondence. Specifically, A0 in D0 corresponds to A0 in D1, A1 in D0 corresponds to B0 in D1, A2 in D0 corresponds to A1 in D1, B0 in D0 corresponds to B1 in D1, B1 in D0 corresponds to A2 in D1, and B2 in D0 corresponds to B2 in D1.

It should be noted that the correspondence that is shown in FIG. 7 and that is between the M×N switching slices included in the two dies that belong to the same die set is merely an example, and does not constitute a limitation on this embodiment of this application. In an actual application, a one-to-one correspondence only needs to exist between the M×N switching slices included in the two dies that belong to the same die set. A specific correspondence may be set based on an actual situation or a requirement. This is not specifically limited in this embodiment of this application.

In another possible embodiment, when each of the plurality of dies includes M×N switching slices, M×N switching slices included in two dies that belong to different die sets, and second interfaces P2 of two corresponding switching slices are coupled. For example, the plurality of die sets include a first die set and a second die set, the first die set includes a first die, the second die set includes a third die, and M×N switching slices included in the first die are in a one-to-one correspondence with M×N switching slices included in the third die.

For example, as shown in FIG. 7, an example in which the plurality of die includes 2×2 dies (denoted as D0 to D3 respectively), and each die includes 2×3 switching slices (denoted as A0 to A2 and B0 to B2 respectively) is used. If D0 belongs to the first die set, D3 belongs to the second die set, D0 is the first die, and D3 is the third die, 2×3 switching slices included in D0 and D3 may be in a one-to-one correspondence. Specifically, A0 in D0 corresponds to A0 in D3, A1 in D0 corresponds to A2 in D3, A2 in D0 corresponds to B1 in D3, B0 in D0 corresponds to A1 in D3, B1 in D0 corresponds to B0 in D3, and B2 in D0 corresponds to B2 in D3.

It should be noted that the correspondence that is shown in FIG. 7 and that is between the M×N switching slices included in the two dies that belong to different die sets is merely an example, and does not constitute a limitation on this embodiment of this application. In an actual application, a one-to-one correspondence only needs to exist between the M×N switching slices included in the two dies that belong to different die sets. A specific correspondence may be set based on an actual situation or a requirement. This is not specifically limited in this embodiment of this application.

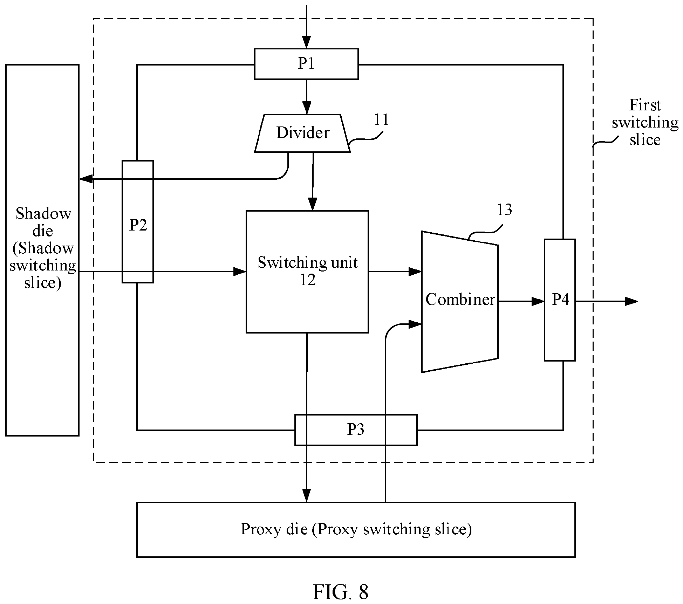

Further, when each of the plurality of dies includes M×N switching slices, for example, as shown in FIG. 8, each of the M×N switching slices may include the divider 11, the switching unit 12, the combiner 13, the first interface P1, the second interface P2, the third interface P3, and the fourth interface P4.

When a structure of each switching slice is shown in FIG. 8, switching slices that belong to a same row in the M×N switching slices are coupled through a first bus 14, and switching slices that belong to a same column are coupled through a second bus 15. Alternatively, switching slices that belong to a same column in the M×N switching slices are coupled through a first bus 14, and switching slices that belong to a same row are coupled through a second bus 15.

In addition, two corresponding switching slices in two dies that belong to a same die set may be coupled through third interfaces P3. For example, when A1 in D0 shown in FIG. 7 corresponds to B0 in D1, a third interface P3 of A0 in D0 may be coupled to a third interface P3 of A0 in D3. Two corresponding switching slices in two dies that belong to different die sets may be coupled through second interfaces P2. For example, when A1 in D0 shown in FIG. 7 corresponds to A2 in D3, a second interface P2 of A1 in D0 may be coupled to a second interface P2 of A2 in D3.

Specifically, for each of the M×N switching slices included in each die (where for ease of description, the switching slice is referred to as a first switching slice in the following), when the first switching slice is configured to implement data transmission in a same die set or between different die sets, the divider 11, the switching unit 12, and the combiner 13 in the first switching slice may be configured to perform the following functions.

The divider 11 is configured to: receive first data through an input end of the divider 11, the first data may be data received by the first switching slice through the first interface P1 from the outside; and output the first data through the first output end of the divider 11 when a destination switching slice (or a destination die) of the first data and the first switching slice belong to a same die set; or output the first data through the second output end of the divider 11 when a destination switching slice (or a destination die) of the first data and the first die belong to different die sets.

The switching unit 12 is configured to: receive second data through the first input end and the second input end of the switching unit 12, where the second data may include data output by the divider 11 through the second output end and data received by the first switching slice through the second interface P2 from a switching slice (which may be referred to as a shadow switching slice) that is in a shadow die and that corresponds to the first switching slice; and output the second data through the first output end of the switching unit 12 when a destination switching slice (or a destination die) of the second data is the first die (or the first switching slice); or output the second data through the second output end of the switching unit 12 when a destination switching slice (or a destination die) of the second data is not the first die (or the first switching slice).

The combiner 13 is configured to: receive third data through the first input end and the second input end of the combiner 13, where the third data may include data output by the switching unit 2 through the second output end and data received by the first switching slice through the third interface P3 from a switching slice (which may be referred to as a proxy switching slice) that is in a proxy die and that corresponds to the first switching slice; and output the third data through the output end of the combiner 13, and then the third data may be output through the fourth interface P4 of the first switching slice.

It should be noted that, for a switching unit 12 of a first switching slice in a first die (where the first die is any die of the plurality of dies), when a destination switching slice of second data received by the switching unit 12 belongs to a shadow die or another die in a die set in which the shadow die is located, but the destination switching slice is not a switching slice that is in the shadow die or the another die and that corresponds to the first switching slice, the switching unit 12 of the first switching slice may send the second data to a shadow switching slice in the shadow die, the shadow switching slice sends the second data to a switching slice that is in the shadow die and that corresponds to the destination switching slice, and then the corresponding switching slice outputs or forwards the second data in the foregoing manner. For example, FIG. 7 is used as an example. If the die sets are divided by column, the first switching slice in the first die is A1 in D0, and the destination switching slice is B2 in D2, A1 in D0 may first send data to B0 in D1, B0 in D1 sends the data to B2 in D1, and then B2 in D1 sends the data to B2 in D2.

Similarly, when the destination switching slice of the second data received by the switching unit 12 of the first switching slice in the first die belongs to a proxy die, but the destination switching slice is not a switching slice that is in the proxy die and that corresponds to the first switching slice, the switching unit 12 of the first switching slice may send the second data to a switching slice that is in the first die and that corresponds to the destination switching slice, and then the corresponding switching slice sends the second data to the destination switching slice in the proxy die. For example, FIG. 7 is used as an example. If the die sets are divided by column, the first switching slice in the first die is A0 in D1, and the destination switching slice is B0 in D2, A0 in D1 may first send data to A1 in D1, and then A1 in D1 sends the data to B0 in D2.

In this embodiment of this application, when each die includes a plurality of switching slices, an I/O interface of a single die may be added. Therefore, when a plurality of dies form a complete apparatus, I/O interfaces of the apparatus can be increased, so that the switching performance of the apparatus is further improved. In addition, when each switching slice includes the structure shown in FIG. 8, each die may be configured to implement data switching in a same die set and between different die sets. In addition, in a data switching process, data needs to be written into only one switching slice, and data switching is performed only once, so that power consumption and a delay of data switching are reduced. In addition, a path for data transmission between different die sets is unique, so that order preserving processing does not need to be performed on a source switching slice and a destination switching slice, and the delay of data switching is further reduced.

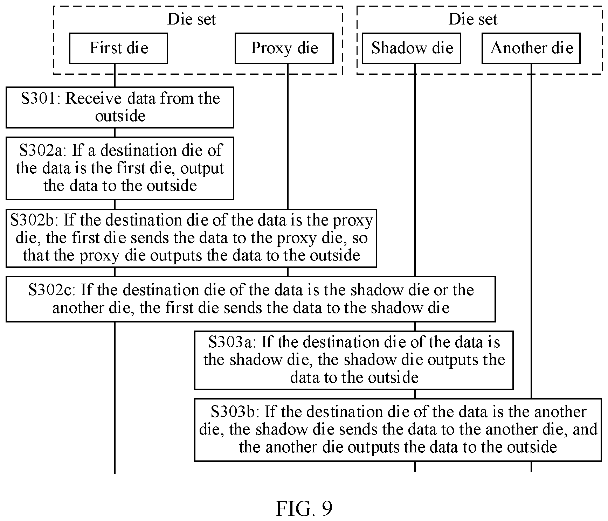

FIG. 9 is a schematic flowchart of a data switching method further provided in an embodiment of this application. The method may be applied to the data switching apparatus provided in the foregoing specification, and the method includes the following steps.

S301: A first die receives data from the outside.

A plurality of dies may include dies of X rows and Y columns, and X and Y are integers greater than 1. The plurality of dies may be divided into a plurality of die sets, and the plurality of die sets may be obtained through division according to rows or columns. In other words, dies in a same row are a die set, or dies in s same column are a die set.

In addition, for a same die set in the plurality of die sets, when data is switched between different chip-level I/O interfaces of a same die or between different dies, the data may be written into a source die. For different die sets in the plurality of die sets, when data is switched between two dies in the different die sets, the data may be written into a shadow die of a source die. The shadow die and the source die belong to different die sets, but belong to a same row or a same column.

S302a: If a destination die of the data is the first die, the first die outputs the data to the outside.

The first die may include a plurality of chip-level I/O interfaces, and the plurality of chip-level I/O interfaces may include an input interface configured to receive data from the outside, and may further include an output interface configured to output data to the outside. When the first die receives the data from the outside, if a destination die of the data is the first die, the first die may write the data and output the data to the outside through the chip-level I/O interface of the first die.

S302b: If the destination die of the data is a proxy die, the first die sends the data to the proxy die, so that the proxy die outputs the data to the outside, where the proxy die and the first die belong to a same die set.

Each of the plurality of die sets may include at least two dies, and the proxy die may be another die in a first die set in which the first die is located. When the destination die of the data is the proxy die, the first die may write the data, and send the data to the proxy die. When the proxy die receives the data, the proxy die may output the data.

S302c: If the destination die of the data is a shadow die or another die in a die set in which the shadow die is located, the first die sends the data to the shadow die, where the shadow die and the first die belong to different die sets, but belong to a same row or a same column.

When the destination die of the data and the first die are not in a same die set, the first die may send the data to the shadow die. The shadow die and the first die are in a same row or a same column, but the shadow die and the first die are not in a same die set. Specifically, if the destination die of the data is a shadow die or another die in a die set in which the shadow die is located, the first die may send the data to the shadow die, and the shadow die may write the data when receiving the data. Then, S303a or S303b is performed.

S303a: If the destination die of the data is the shadow die, the shadow die outputs the data to the outside.

S303b: If the destination die of the data is the another die in the die set in which the shadow die is located, the shadow die sends the data to the another die, and the another die outputs the data to the outside.

Further, each die in the plurality of die sets includes a divider, a switching unit, a combiner, a first interface, a second interface, a third interface, and a fourth interface. An input end of the divider is coupled to the first interface, a first output end of the divider is coupled to a first input end of the switching unit, a second output end of the divider and a second input end of the switching unit are both coupled to the second interface, a first output end of the switching unit is coupled to a first input end of the combiner, a second output end of the switching unit and a second input end of the combiner are both coupled to the third interface, and an output end of the combiner is coupled to the fourth interface. In the plurality of die sets, third interfaces of dies that belong to a same die set are coupled, and second interfaces of dies that belong to different die sets are coupled.

Specifically, the foregoing method may be as follows: The divider receives first data through an input end of the divider (that is, receives data from the outside), and the divider outputs the first data through the first output end of the divider when a destination die of the first data and the first die belong to a same die set, or the divider outputs the first data through the second output end of the divider when a destination die of the first data and the first die belong to different die sets (that is, the divider sends the data to the shadow die when the destination die of the data is the shadow die or another die in a die set in which the shadow die is located); the switching unit receives second data through the first input end and the second input end of the switching unit, and the switching unit outputs the second data through the first output end of the switching unit when a destination die of the second data is the first die, or the switching unit outputs the second data through the second output end of the switching unit when a destination die of the second data is not the first die (that is, the switching unit sends the data to the proxy die when the destination die of the data is the proxy die); and the combiner receives third data through the first input end and the second input end of the combiner, and outputs the third data through the output end of the combiner (that is, the combiner outputs the data when the destination die of the data is the first die).

It should be noted that all related content in the foregoing apparatus embodiment may be correspondingly referenced to the method embodiment, and details are not described herein again in this embodiment of this application.

In the data switching method provided in this embodiment of this application, each die in the plurality of die sets may be configured to implement data switching in a same die set and between different die sets. In addition, in a data switching process, data needs to be written into only one die, and data switching is performed only once, so that power consumption and a delay of data switching are reduced. In addition, a path for data transmission between different die sets is unique, so that order preserving processing does not need to be performed on a source die and a destination die, and the delay of data switching is further reduced.

Based on this, an embodiment of this application further provides a chip. The chip may be a chip having a data switching function, and the chip may include any data switching apparatus provided above.

In another aspect of this application, a data switching device is further provided, and the data switching device may include any data switching apparatus provided above. Optionally, the data switching device may be a switch, a router, or the like.

It should be noted that, for related descriptions of the data switching apparatus in the chip and the data switching device that are provided above, refer to the descriptions in the apparatus embodiment provided above. Details are not described herein again in this embodiment of this application.

According to still another aspect of this application, a computer-readable storage medium is provided. The computer-readable storage medium includes computer instructions. When the computer instructions are run, the data switching method provided in the foregoing method embodiment is performed.

According to still another aspect of this application, a computer program product including instructions is provided. When the computer program product runs on a computer, the computer can perform the data switching method provided in the foregoing method embodiment.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A data switching apparatus, wherein the data switching apparatus comprises a plurality of dies, and each of the plurality of dies comprises a divider, a switching unit, a combiner, a first interface, a second interface, a third interface, and a fourth interface;
an input end of the divider is coupled to the first interface, a first output end of the divider is coupled to a first input end of the switching unit, a second output end of the divider and a second input end of the switching unit are both coupled to the second interface, a first output end of the switching unit is coupled to a first input end of the combiner, a second output end of the switching unit and a second input end of the combiner are both coupled to the third interface, and an output end of the combiner is coupled to the fourth interface; and
a third interface of each of the plurality of dies is coupled to a third interface of another of the plurality of dies, and a second interface of each of the plurality of dies is coupled to a second interface of still another of the plurality of dies.

2. The apparatus according to claim 1, wherein the plurality of dies are interconnected to form a switch fabric, and the first interface and the fourth interface of each of the plurality of dies are respectively configured to serve as an input interface and an output interface of the switch fabric.

3. The apparatus according to claim 1 or 2, wherein the plurality of dies comprise a first die, a second die, a third die, and a fourth die, a third interface of the first die is coupled to a third interface of the second die, a third interface of the third die is coupled to a third interface of the fourth die, a second interface of the first die is coupled to a second interface of the third die, and a second interface of the second die is coupled to a second interface of the fourth die.

4. The apparatus according to claim 3, wherein for the first die,
the divider is configured to: receive first data through an input end of the divider, and output the first data through a first output end of the divider when a destination die of the first data is the first die or the second die, or output the first data through a second output end of the divider when a destination die of the first data is the third die or the fourth die;
the switching unit is configured to: receive second data through a first input end and a second input end of the switching unit, and output the second data through a first output end of the switching unit when a destination die of the second data is the first die, or output the second data through a second output end of the switching unit when a destination die of the second data is the second die; and
the combiner is configured to: receive third data through a first input end and a second input end of the combiner, and output the third data through an output end of the combiner.

5. The apparatus according to any one of claims 1 to 4, wherein each die comprises M×N switching slices, each of the M×N switching slices comprises a splitter, a switching unit, a combiner, a first interface, a second interface, a third interface, and a fourth interface, and M and N are positive integers, wherein
second interfaces of switching slices that belong to a same row in the M×N switching slices are coupled through a first bus, and third interfaces of switching slices that belong to a same column are coupled through a second bus.

6. The apparatus according to claim 5, wherein the plurality of dies comprise the first die and the second die, M×N switching slices comprised in the first die are in a one-to-one correspondence with M×N switching slices comprised in the second die, and third interfaces of two corresponding switching slices are coupled.

7. The apparatus according to claim 5 or 6, wherein the plurality of dies comprise the first die and the third die, the M×N switching slices comprised in the first die are in a one-to-one correspondence with M×N switching slices comprised in the third die, and second interfaces of two corresponding switching slices are coupled.

8. The apparatus according to any one of claims 1 to 7, wherein there is one virtual output interface corresponding to a third interface of either of two dies that are in the plurality of dies and whose third interfaces are coupled, and the virtual output port of either of the two dies is corresponding to a fourth interface of the other die.

9. The apparatus according to any one of claims 1 to 8, wherein the plurality of dies comprise a plurality of die sets, third interfaces of dies comprised in a same die set are coupled, and second interfaces of dies comprised in different die sets are coupled.

10. The apparatus according to claim 9, wherein data switched between two dies that belong to different die sets is written into a die in a die set in which a destination die is located.

11. The apparatus according to claim 10, wherein when a source die and the destination die in the two dies belong to a same row or column, the data is written into the destination die; or when a source die and the destination die in the two dies belong to different rows or columns, the data is written into a die that is in the die set in which the destination die is located and that is in a same row or column as the source die.

12. The apparatus according to any one of claims 9 to 11, wherein data switched between two dies that belong to a same die set is written into a source die.

13. A chip, wherein the chip comprises the data switching apparatus according to any one of claims 1 to 12.

14. A data switching method, applied to a data switching apparatus comprising a plurality of dies, wherein each of the plurality of dies comprises a divider, a switching unit, a combiner, a first interface, a second interface, a third interface, and a fourth interface; an input end of the divider is coupled to the first interface, a first output end of the divider is coupled to a first input end of the switching unit, a second output end of the divider and a second input end of the switching unit are both coupled to the second interface, a first output end of the switching unit is coupled to a first input end of the combiner, a second output end of the switching unit and a second input end of the combiner are both coupled to the third interface, and an output end of the combiner is coupled to the fourth interface; the plurality of dies comprise a first die, a second die, a third die, and a fourth die, a third interface of the first die is coupled to a third interface of the second die, a third interface of the third die is coupled to a third interface of the fourth die, a second interface of the first die is coupled to a second interface of the fourth die, and a second interface of the second die is coupled to a second interface of the third die; and the method comprises:
receiving, by the divider, first data through the input end of the divider, and outputting the first data through the first output end of the divider when a destination die of the first data is the first die or the second die, or outputting the first data through the second output end of the divider when a destination die of the first data is the third die or the fourth die;
receiving, by the switching unit, second data through the first input end and the second input end of the switching unit, and outputting the second data through the first output end of the switching unit when a destination die of the second data is the first die, or outputting the second data through the second output end of the switching unit when a destination die of the second data is the second die; and
receiving, by the combiner, third data through the first input end and the second input end of the combiner, and outputting the third data through the output end of the combiner.
